# EUROPEAN PATENT SPECIFICATION

(11) **EP 2 507 839 B1**
(45) Date of publication and mention of the grant of the patent: **04.04.2018**
(21) Application number: 10787731.8
(22) Date of filing: 29.11.2010
(51) Int. Cl.: H01L 31/05

(54) **METHOD FOR MANUFACTURING PHOTOVOLTAIC MODULES COMPRISING BACK-CONTACT CELLS**
HERSTELLUNGSMETHODE FÜR SOLARZELLENMODULE MIT RÜCKSEITENKONTAKTIERTEN ZELLEN
PROCÉDÉ DE FABRICATION DE MODULES PHOTOVOLTAÏQUES COMPRENANT DES CELLULES À CONTACT ARRIÈRE

(30) Priority: 30.11.2009 US 265255 P
(43) Date of publication of application: 10.10.2012
(73) Proprietor: IMEC VZW, 3001 Leuven (BE)
(72) Inventor: BAERT, Kris, 3001 Leuven (BE)
(74) Representative: Hertoghe, Kris Angèle Louisa
(86) International application number: PCT/EP2010/068423
(87) International publication number: WO 2011/064368

(56) References cited:
- WO-A1-2006/137746
- WO-A1-2007/128305
- GB-A- 2 459 274

## Description

### Field of the invention

This invention relates to photovoltaic modules, more in particular to photovoltaic modules comprising thin back-contact photovoltaic cells, e.g. with a thickness of less than 180 micrometer, and to methods for manufacturing such photovoltaic modules.

### Background of the invention

There is a need for a reduction of the cost of crystalline silicon photovoltaic cells and modules and at the same time there is a need for higher energy conversion efficiencies.

As a significant part of the cost of a crystalline silicon photovoltaic module can be attributed to the cost of the silicon substrates used, working with thinner crystalline silicon substrates can lead to a cost reduction of the module. For thinner substrates (e.g. for substrates with a thickness of lessthan 180 micrometer, e.g. down to 5 micrometer) there is a need for suitable fabrication processes, because thin substrates are more susceptible to breakage as compared to thicker cells. Breakage may for example be induced by thermal, mechanical or thermo-mechanical stress. During processing of thin substrates, e.g. substrates with a thickness down to 5 micrometer, warpage may exceed the maximum level allowed for by the handling and process equipment. Warpage may for example occur as a result of a metallization process. It may e.g. be caused by built-in internal stress of a deposited layer and/or thermal stress resulting from a different TCE (Thermal Coefficient of Expansion) between the materials used, e.g. between a silicon substrate and a metal layer. Both breakage and warpage can substantially impact the yield of a production process and therefore the cost of photovoltaic cells and modules.

Another aspect that may lead to cost reduction of photovoltaic cells and modules may be in increasing the number of silicon substrates that can be processed in one machine run, since the process cost per area decreases when the process area increases. There is an upper limit to this since it becomes increasingly difficult to maintain uniformity over larger areas.

For realizing higher energy conversion efficiencies, back-contact photovoltaic cells, i.e. photovoltaic cells having both conductive electrodes located at the back side of the cells, may advantageously be used since this type of cells has no shadowing loss or substantially less shadowing loss as compared to cells with front side contacts.

Methods have been proposed for fabricating photovoltaic modules comprising back-contact photovoltaic cells. For example, in GB-2459274-A, in US2008/0236655 and in US5,972,732 a backplane comprising a plurality of interconnect pads and electrical conductors is provided. The conductive contacts of back-contact photovoltaic cells are placed in alignment with these interconnect pads. These methods have some disadvantage as they require the consecutive manufacturing and alignment of several layers of metallization, which implies significant cost and risk of failure during lifetime. Also, in the case of thin back contact solar cells, the thermal and mechanical stress exercised on the photovoltaic cell during the contacting process may be critical in view of the substrate fragility. The intermediate contact material (e.g. solder or conductive adhesive) between the metal contacts of the photovoltaic cell and the conductors on the backplane may be a source of high localized stress.

Patent Application US2008/0160661 discloses a method for forming a photovoltaic cell structure using a layer transfer technique, wherein a layer of material (a slice) is removed from a semiconductor substrate by a controlled cleaving action after coupling it to an optically transparent substrate, and wherein photovoltaic cells are fabricated from the transferred layer. This method comprises providing a plurality of single crystal silicon slices; supporting this plurality of slices on a common process chuck; forming one or more photovoltaic regions on each of the plurality of supported slices; coupling each of the plurality of slices to an optical plate; and forming one or more contact regions on each of the plurality of slices. This method has as an advantage that all of the slices within a given photovoltaic module can be processed simultaneously, thereby improving throughput and lowering the cost of fabricating a module. The method can for example be used for forming a photovoltaic module comprising thin back-contact photovoltaic cells.

### Summary of the invention

It is an object of embodiments of the present invention to provide good photovoltaic modules comprising a plurality of photovoltaic cells.

The above objective is accomplished by a method according to claim 1 and a device according to claim 9. One aspect of the present invention relates to a method for fabricating photovoltaic modules, e.g. photovoltaic modules comprising back-contact photovoltaic cells, e.g. silicon back-contact photovoltaic cells, wherein the number of process steps is reduced as compared to prior art methods. Reducing the number of process steps may lead to a cost reduction and an increased throughput. The method of the present invention may be used for fabricating photovoltaic modules comprising thin back-contact photovoltaic cells, with a reduced risk of warpage and/or breakage as compared to prior art solutions. In embodiments of the present invention rear side processing of the plurality of photovoltaic cells is performed at module-level and a single metallization process is used for forming metal contacts to the cells and for interconnecting cells within a module.

A method for fabricating a photovoltaic module according to an embodiment of the present invention comprises: providing a plurality of photovoltaic substrates having a front side (e.g. substrates with processed front side); attaching the plurality of photovoltaic substrates to a transparent carrier with the front side of the photovoltaic substrates facing the carrier; and rear side processing of the plurality of photovoltaic substrates for forming photovoltaic cells, wherein rear side processing comprises a single metallization process for forming electrical contacts to n-type regions and to p-type regions at the rear side of the plurality of photovoltaic cells and for interconnecting the photovoltaic cells within the photovoltaic module.

In embodiments of embodiments of the present invention, the substrates can be silicon substrates, e.g. thin silicon substrates (e.g. thinner than 180 micrometer, thinner than 150 micrometer, thinner than 100 micrometer, thinner than 80 micrometer, thinner than 60 micrometer, thinner than 50 micrometer, or thinner than 40 micrometer, down to 5 micrometer). The photovoltaic cells may be back contact photovoltaic cells.

The single metallization process for forming electrical contacts to n-type regions and to p-type regions at the rear side of the plurality of photovoltaic cells and for interconnecting the photovoltaic cells (or merged metallization step) may comprise forming a patterned seed layer and performing a metal plating step. Alternatively, the merged metallization step may comprise performing a screen printing step using a low temperature curing metal paste. In particular embodiments stress relief structures may be provided for reducing or limiting stress in metal interconnections between photovoltaic cells.

A method according to one aspect may further comprise encapsulating the plurality of photovoltaic cells.

In a method according to embodiments of the present invention, rear side processing may be performed after attaching the plurality of photovoltaic substrates to the transparent carrier. Rear side processing may comprises one or more of the following rear side processing steps: coating, diffusion of dopants, deposition of layers, etching, applying lithographic steps, locally removing part of deposited layers, growth of at least one epitaxial layer, a printing step.

In accordance with embodiments of the present invention, rear side processing may be carried out at temperatures sufficiently low to prevent deterioration of materials used.

In a second aspect, the present invention provides a photovoltaic module comprising a plurality of photovoltaic cells which are electrically interconnected, wherein a single metallization level is used for making electrical contacts to n-type regions and to p-type regions at the back side of the plurality of photovoltaic cells and for electrically interconnecting photovoltaic cells within the module. In particular embodiments, the single metallization level may comprise a stack of layers.

The single metallization level may have an equivalent contact resistance to the n-type and p-type regions of the photovoltaic cells of less than 0.1 Ohm cm², for example but not limited thereto between 1 mΩ cm² and 0.1 Ω cm².

In a photovoltaic module according to embodiments of the present invention, the plurality of photovoltaic cells may be attached to a transparent carrier. The transparent carrier may be a flexible carrier.

In a further aspect, the present invention provides the use of a method according to claim 14 for fabricating photovoltaic modules comprising back contact photovoltaic cells. The use of such method is advantageous in that only a limited number of processing steps are required to complete the fabrication of a photovoltaic module.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing certain inventive aspects and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the invention. The invention, both as to organization and method of operation, together with features and advantages thereof, may best be understood by reference to the following detailed description when read in conjunction with the accompanying drawings.

### Brief description of the drawings

FIG. 1 to FIG. 4 illustrate process steps of a photovoltaic module fabrication method according to one embodiment of the present invention.
FIG. 5 illustrates partial embedding of photovoltaic substrates into an adhesive layer according to embodimentsof the present invention.
FIG. 6 to FIG. 8 illustrate process steps of a photovoltaic module fabrication method with merged metallization according to an embodiment of the present invention.
FIG. 9 shows a top view of a structure after providing a seed layer for the merged metallization step in a module fabrication process according to embodiments of the present invention.
FIG. 10 to FIG. 14 illustrate an exemplary sequence of rear side processing steps that may be performed at module level in accordance with embodiments of the present invention.
FIG. 15 illustrates stress relief structures being provided in accordance with embodiments of the present invention for reducing or limiting stress in metal interconnections between photovoltaic cells.

In the different drawings, the same reference signs refer to the same or analogous elements. Any reference signs in the claims shall not be construed as limiting the scope.

### Detailed description of illustrative embodiments

In the following detailed description, numerous specific details are set forth in order to provide a thorough understanding of the invention and how it may be practiced in particular embodiments. However, it will be understood that embodiments of the present invention may be practiced without these specific details. In other instances, well-known methods, procedures and techniques have not been described in detail, so as not to obscure the teaching of the present invention. While the present invention will be described with respect to particular embodiments and with reference to certain drawings, the invention is not limited hereto. The drawings included and described herein are schematic and are not limiting the scope of the invention. It is also noted that in the drawings, the size of some elements may be exaggerated and, therefore, not drawn to scale for illustrative purposes.

Furthermore, the terms first, second, third and the like in the description are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequencesthan described or illustrated herein.

Moreover, the terms top, bottom, over, under and the like in the description are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising" should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B' should not be limited to devices consisting only of components A and B.

In the context of the present invention, the front surface or front side of a photovoltaic cell or of a photovoltaic module is the surface or side adapted for being oriented towards a light source and thus for receiving illumination. The back surface, rear surface, back side or rear side of a photovoltaic cell or a photovoltaic module is the surface or side opposite to the front surface or side.

In the context of the present invention, 'photovoltaic substrate' is used for indicating a substrate on which front side processing for forming a photovoltaic cell has already been performed, and on which rear side processing for forming a photovoltaic cell is not yet finished. Front side processing refers to all process steps that are performed at the front side of the substrate in a process for forming a photovoltaic cell. Rear side processing refersto all process steps that are performed at the rear side of the substrate in a process for forming a photovoltaic cell.

In the context of the present invention, a back-contact cell is a cell that comprises electrical contactsto n-type regions and to p-type regions at least at the back side of the cell.

The invention will now be described by a detailed description of several embodiments thereof. It is clear that other embodiments of the invention can be configured according to the knowledge of persons skilled in the art without departing from the technical teaching of the invention, the invention not being limited thereto.

One embodiment of the present invention relates to a method for fabricating photovoltaic modules, e.g. photovoltaic modules comprising back-contact photovoltaic cells, e.g. silicon back-contact photovoltaic cells, wherein the number of process steps is reduced as compared to prior art methods. Reducing the number of process steps may lead to a cost reduction and an increased throughput. The method of the present invention may be used for fabricating photovoltaic modules comprising thin (e.g. thinner than 180 micrometer, thinner than 150 micrometer, thinner than 100 micrometer, thinner than 80 micrometer, thinner than 60 micrometer, thinner than 50 micrometer, or thinner than 40 micrometer, down to 5 micrometer) back-contact photovoltaic cells, with a reduced risk of warpage and/or breakage ascompared to prior art solutions.

Although the method is further described for the case of silicon photovoltaic cells, the photovoltaic cells may be silicon cells, germanium cells, or cells made in or from any other suitable semiconductor material.

For photovoltaic cells having both n-type and p-type contacts at the same side of the cell (e.g. at the back side of the cell), both types of cell contacts can be formed using a single metallization step. When such cells are incorporated into a photovoltaic module, a metallization step at module level is needed for electrically connecting cells to one another. Alternatively, module-level interconnection pads can be provided, for example on a backplane, and the photovoltaic cells can be placed on the backplane with their contacts properly aligned to the interconnection pads. In these prior art methods, at least two different metallization steps are used in a process for manufacturing photovoltaic modules with back-contact photovoltaic cells: a first metallization step or process for forming electrical contacts to the n-type and p-type regions of the photovoltaic cells and a second metallization step or process for electrically connecting the photovoltaic cells within a module with each other.

One embodiment of the present invention relates to a method for fabricating photovoltaic modules comprising back-contact photovoltaic cells, wherein the number of process steps is further reduced ascompared to prior art solutions. This reduction of the number of process steps is obtained by merging different steps, more in particular by merging different metallization steps, e.g. by merging the steps of forming electrical contacts to p-type and n-type regions of the photovoltaic cells (including electrically connecting within a photovoltaic cell the n-type regions, respectively the p-type regions, with each other), and the step of cell to cell interconnection to form a photovoltaic module. This merged metallization can for example be performed after transferring and fixing a plurality of photovoltaic substrates to a carrier, e.g. a rigid carrier. The method can advantageously be used for fabricating modules comprising thin back-contact photovoltaic cells, e.g. with a thickness in the range between 5 micrometer and 180 micrometer, e.g. in the range between 5 micrometer and 100 micrometer, e.g. between 40 micrometer and 60 micrometer. By attaching the thin photovoltaic substrates to a rigid carrier before performing the metallization step, wafer warpage can be avoided. In embodiments of the present invention, besides the rear side metallization, other rear side processing steps, such as for example coating and diffusion of dopants, deposition of layers (e.g. dielectric layers or amorphous semiconductor layers), etching (e.g. etching of silicon for texturing), applying lithographic steps, locally removing (part of) deposited layers e.g. by laser ablation, surface passivation, growth of epitaxial layers, printing steps etc, can be done after transferring and attaching the photovoltaic substrates to a carrier, e.g. a rigid carrier. For thin substrates, this may lead to a reduction of the risk of breakage.

In embodiments of the present invention photovoltaic modules with a merged metallization are provided, e.g. one metallization level is used for making electrical contacts to the n-type regions and to the p-type regions at the back side of the photovoltaic cells (at the same time electrically connecting n-type regions within a photovoltaic cell and electrically connecting p-type regions within a photovoltaic cell) and for electrically connecting photovoltaic cells within a module, e.g. electrically connecting the n-type regionsof one cell to the p-type regionsof another cell. In other words, a single metallization step or process is used for simultaneously forming electrical contacts to n-type regions and p-type regions of at least two, e.g. a plurality of, photovoltaic cells and for electrically connecting n-type regions of one photovoltaic cell to p-type regionsof another photovoltaic cell, e.g. a neighboring photovoltaic cell.

The single metallization level can comprise a stack of layers. It may have a good equivalent contact resistance to the n-type and p-type regions of the photovoltaic cells, for example less than 0.1 Ohm cm². This can be obtained e.g. by using at the semiconductor surface (the surface of the n-type and/or p-type material) a material (such as e.g. Ti, TiN, Ta, TaN, NiSi, silicides, salicides or any other suitable material known to a person skilled in the art) with a good electrical contact to n-type and p-type layers. Furthermore, the single metallization level may have a high electrical conductivity, for example between 3x10⁶ S/m and 6x10⁷ S/m, e.g. between 8x10⁶ S/m and 6x10⁷ S/m, e.g. by using a material (such as e.g. Cu) with a good electrical conductivity for forming the electrical connections and/or by making the metallization sufficiently thick (e.g. in the order of 10 micrometer or thicker). Rear side processing may be done at low temperatures, for example at temperatures that are sufficiently low to prevent deterioration of the materials used (carrier or superstrate, adhesive layer, encapsulation layers,..) and to prevent deterioration of the passivating properties of passivated interfaces and bulk. Processing may for example be done at temperatures below 250ºC. The aspect ratio of the rear side metallization may be in the range between 0.1 and 100. The single level of metallization may comprise a stack of layers, providing at the same time a good contact to the n- and p- regions of the photovoltaic cells and a good electrical interconnection between photovoltaic cells. For rear side metallization, a method may be used that allows direct patterning. For example, such a method may comprise providing a seed layer, e.g. through metal jetting or by thin film deposition and patterning, followed by a plating step, or it may comprise performing a screen printing step using a metal paste that can be cured at low temperature.

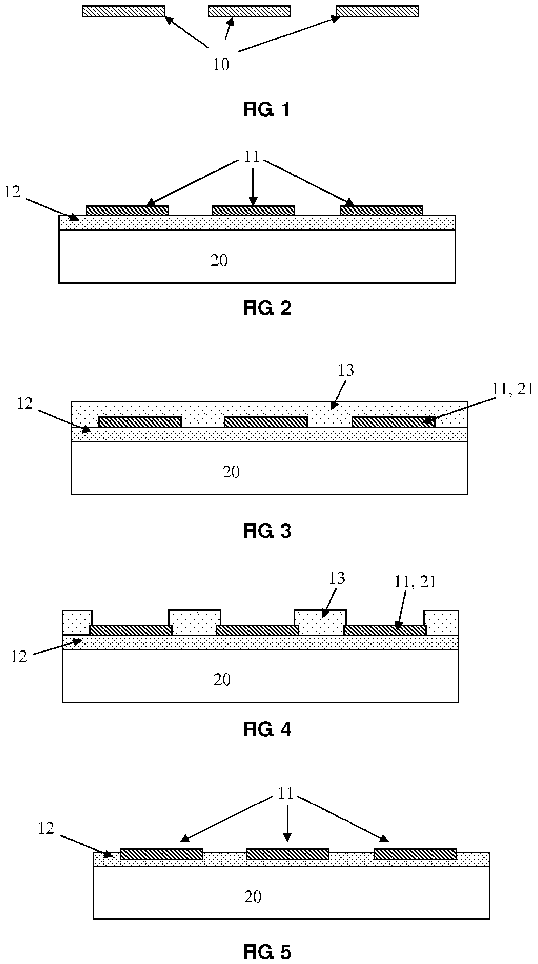

A method for fabricating a photovoltaic module with a merged metallization step according to an embodiment of the present invention is illustrated in FIG. 1 to FIG. 4.

In a first step a plurality of semiconductor substrates, such as silicon substrates, e.g. thin silicon substrates 10, is provided (FIG. 1). Thin silicon substrates 10 can be formed by known methods, such as for example methods described in EP 1858087, methods disclosed in US7,022,585 or in US6,649,485 and US6,964,732, methods according to US2008/0160661 or any other suitable method known by a person skilled in the art.

Front side processing can for example be done before forming the thin silicon substrates 10 (e.g. before releasing thin silicon slices from a thick silicon wafer or e.g. from an ingot). Alternatively, front side processing may be done after forming the thin silicon substrates 10. In this case the thin substrates 10 can advantageously be positioned on a support during front side processing, e.g. a temporary support. Front side processing refers to all process steps that are performed at the font side of the plurality of substrates 10 in a process for forming photovoltaic cells. Front side processing can for example comprise surface texturing and/or providing a front surface field, and/or providing an antireflection coating. Front side processing can be done on a plurality of substrates simultaneously.

After front side processing, the plurality of silicon substrates with processed front side (further called photovoltaic substrates 11) are transferred to and attached to a transparent carrier 20 or superstrate, e.g. by means of an adhesive layer 12, with the front side (i.e. the processed side) of the photovoltaic substrates 11 facing the transparent carrier 20. This is illustrated in FIG. 2. It is an advantage of attaching the photovoltaic substrates 11 to the transparent carrier 20 just after front side processing (before rear side processing) that the rear side processing can be done for all substrates 11 simultaneously. Moreover, especially for fragile thin substrates 11 it is an advantage that they are protected against cracking during handling and processing as soon as they are mounted on the superstrate 20.

In a finalized photovoltaic module the transparent carrier 20 may act asa front side module layer or as a "superstrate". The transparent superstrate may for example be a glass superstrate, a ceramic superstrate, a plastic or a polymeric superstrate. The superstrate may have a TCE that is sufficiently close to the TCE of the semiconductor substrate used for the photovoltaic substrates 11. With "sufficiently close" is meant "in the same order of magnitude", for example below 10 ppm/K; e.g. in case of a silicon substrate the superstrate may be soda-line glass with a TCE of 8 ppm/K The superstrate may be sufficiently rigid to provide mechanical strength to the photovoltaic modules, for example sufficiently rigid for flat modules for outdoor applications. Furthermore, it may be compatible with the subsequent processing steps, e.g. with temperatures and/or chemicals used in subsequent processing steps. The superstrate may also provide protection against elements in the environment during field operation such as moisture, temperature, impact e.g. from hail or gravel, UV light, acidic rain, dirt and cleaning agents.

In embodiments of the present invention the superstrate can be a flexible superstrate. In such embodiments the requirement of a TCE close to the ICE of the semiconductor substrate may be relaxed by using a symmetrical layer build-up, e.g. by providing a layer similar to the superstrate at the rear side of the photovoltaic module for compensating TCE-related stresses induced by the superstrate at the front side of the photovoltaic substrates 11. Additional barrier layers may be provided on the superstrate e.g. flexible superstrate, to provide sufficient protection against elements in the environment during field operation.

A process for transfer and attachment of the plurality of silicon photovoltaic substrates 11 to the superstrate 20 according to embodiments of the present invention can be as follows. First an adhesive layer 12, such as for example a silicone layer, with good adhesion properties to both the photovoltaic substrate 11 and the transparent superstrate 20 is applied on the superstrate 20 or on the front side of the thin photovoltaic substrates 11 or on both the transparent superstrate 20 and the front side of the photovoltaic substrates 11. Providing the adhesive layer 12 can be done by methods known by a person skilled in the art, such as for example by blade coating, spray coating, knife-over-roll coating, dip coating or printing techniques such as dispensing and gravure-printing, or by lamination. Next a plurality of photovoltaic substrates 11 (wherein only the front side processing such as texturing, providing an antireflection coating, etc...has been performed) are placed on the superstrate 20 (with an adhesive layer 12 in between), with the front side of the plurality of photovoltaic substrates 11 oriented towards the superstrate 20, such that the back side or rear side of the photovoltaic substrates 11 remains available for processing at that side. Bonding can be achieved by methods known by a person skilled in the art ("wafer placement") but being fitted with features from wafer-to-wafer bonders (such as application of a pressure, temperature and methods for avoiding trapping of air bubbles).

Air bubbles between the front surface of the photovoltaic substrates 11 and the superstrate 20 may be introduced during the placement step and may cause loss of performance of the photovoltaic module. Any formation of air bubbles in between a photovoltaic substrate 11 and the superstrate 20 may therefore be avoided, because air in between the photovoltaic cells and the superstrate would lead to light scattering and unmatched interfaces, thereby reducing the amount of energy that can reach the front side of the photovoltaic cells. To avoid air bubbles, there are different possibilities. One way would be to do the placement in a low pressure or vacuum chamber, wherein the pressure in the chamber is sufficiently low to avoid air bubbles and wherein the pressure difference between the chamber and a chuck is sufficiently high to pick up a photovoltaic substrate but sufficiently low to avoid breakage of the substrate. Another way of avoiding air bubbles may be using a curved chuck or a chuck that is not fully parallel with the superstrate 20 or by pre-flexing the photovoltaic substrates 11 prior to placement onto the superstrate 20. In this way, one point of a photovoltaic substrate 11 reaches the surface of the adhesive layer 12 first and gradually presses away the air towards the edgesof the photovoltaic substrate 11 until the photovoltaic substrate 11 is in full contact with the surface of the adhesive layer 12. Another technique that may be used comprisesdispensing a dot of glue on the superstrate 20 where the center of a photovoltaic substrate 11 is to be placed. This technique can for example be used in cases where the photovoltaic substrates 11 are attached to a temporary supporting carrier or supporting substrate (e.g. US7,022,585) or to an original substrate (e.g. EP1858087). After transfer and attachment to the superstrate 20, the supporting substrate or temporary supporting carrier can be removed.

In embodiments of the present invention, the photovoltaic substrates 11 can be pressed into the adhesive layer 12, such that the topography of the resulting structure (more in particular the steps at the sides of the photovoltaic substrates 11) is reduced or eliminated. This is schematically illustrated in FIG. 5.

As light will pass through the superstrate 20 and through the adhesive layer 12 when the photovoltaic module is in use, both are advantageously transparent for wavelengths of light that can be absorbed by the photovoltaic cells, and the superstrate 20 and the adhesive layer 12 may have matched refractive indexes so as to minimize reflection. The adhesive layer 12 may not be degraded by the impinging light, and may have a refractive index that matches between the photovoltaic cell (more in particular the top layer of the photovoltaic cell, e.g. an antireflection coating) and the module superstrate 20. The adhesive layer 12 may have a TCE sufficiently close to the TCE of the semiconductor material of the photovoltaic substrate 11 and the superstrate 20 material and may be highly elastic (allowing stress relief) as compared to the semiconductor material and the superstrate material. Examples of such layers are spin-on glass, silicones and epoxies. For example, Slicone PV6010 Cell Encapsulant can be used as an adhesion layer 12. This material has a high transparency and a high dielectric strength in combination with a low E x TCE product, wherein E is Young's modulus and ICE is the Thermal Coefficient of Expansion. Hence the resulting adhesive layer 12 may be very soft, which is beneficial for low-stress embedding. It may also feature very good self-priming adhesion and humidity resistance. Other materials with suitable properties known by a person skilled in the art may be used for forming an adhesive layer 12.

After attaching the plurality of photovoltaic substrates 11 to the superstrate 20, an encapsulation layer 13 can be provided at the side of the photovoltaic substrates 11, e.g. at least in between photovoltaic substrates 11, optionally in between and on top of the backside of photovoltaic substrates 11, as illustrated in FIG. 3 and FIG. 4. In particular embodiments of the present invention, at least part of the rear side processing of the photovoltaic substrates 11 may be performed before providing the encapsulation layer 13. In embodimentsof the present invention, rear side or back side processing of the plurality of photovoltaic substrates 11 to form photovoltaic cells may be done at module level (i.e. simultaneously for the plurality of photovoltaic substrates 11 within a module). Rear side processing may for example include coating and diffusion of dopants, deposition of layers such as e.g. metallic, dielectric and/or semiconducting layers, etching, e.g. etching of silicon for texturing, lithographic steps, locally removing part of deposited layers e.g. by laser ablation or by etching, growth of epitaxial layers, coating an encapsulation layer and forming vias towards the cell, e.g. by laser ablation, and/or back side metallization.

For example, during rear side processing, a base-emitter junction can be formed. This can be achieved by different techniques, such as doping or directly depositing an emitter layer, e.g. a doped PECVD amorphous silicon layer. In embodiments of the present invention it is advantageous to form the base-emitter junction before the step of providing the encapsulation layer 13. Possible additional process steps include providing a window in the emitter layer to contact the underlying base layer, depositing and patterning an insulation layer and formation of a back surface field at the base contacts. The process conditions may be selected such that the rear side processing does not negatively affect the other layers (such as the adhesive layer) of the structure. For example, the rear side processing steps may be performed at temperatures that are compatible with the different materials of the structure, such as e.g. the superstrate 20, the adhesive layer 12 and encapsulation layer 13. As an example, the rear side processing may be done at temperatures lower than 200°C. In the drawings, the photovoltaic substrates after (at least) partial rear side processing are indicated with reference number 21.

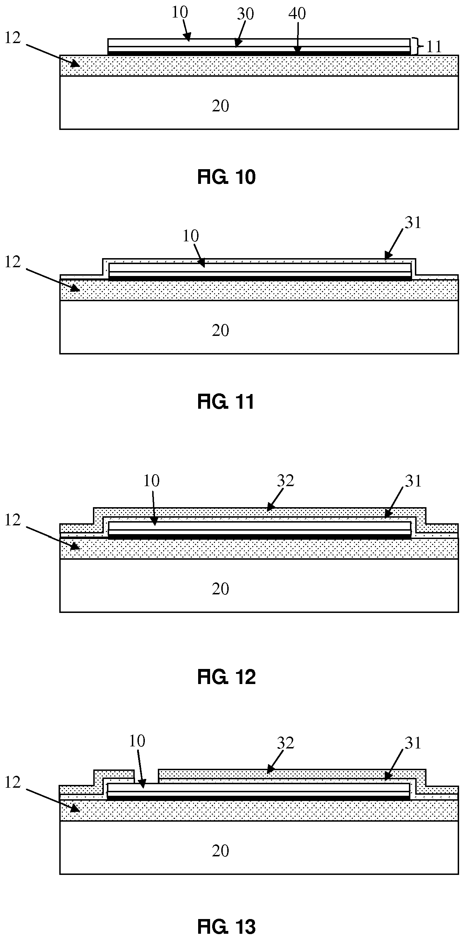

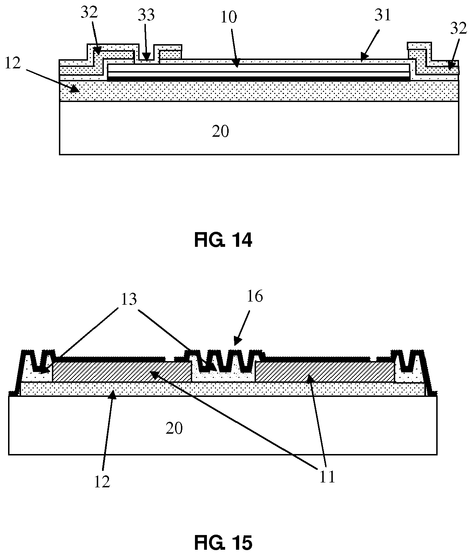

An example of rear side processing steps that may be performed at this stage of the process is schematically illustrated in FIG. 10 to FIG. 14. For example, as shown in FIG. 10, the photovoltaic substrates 11 may comprise a thin semiconductor substrate of first dopant type, e.g. a thin n-type crystalline silicon substrate 10 with a textured front surface (not shown), a region of the first dopant type with a higher dopant concentration than the semiconductor substrate of the first dopant type, e.g. an n+ region 30, at the front surface for providing a front surface field and an antireflection coating 40 at the front surface. After attaching a plurality of photovoltaic substrates 11 to the superstrate 20 (as illustrated in FIG. 2 and FIG. 10), and after performing a cleaning step, a semiconductor layer of a second dopant type, e.g. a p+ amorphous silicon layer 31, can be deposited on the rear side of the photovoltaic substrates 11 in any suitable way, e.g. by means of PECVD, for forming an emitter layer, thus providing a semiconductor junction with the silicon substrate 10 (acting as the base layer). In the example shown, the emitter layer 31 is a p-type amorphous silicon layer and the base layer is an n-type crystalline silicon substrate 10. However, in other embodiments the emitter layer can be an n-type amorphous silicon layer and the base layer can be a p-type crystalline silicon substrate. In a next step, illustrated in FIG 12, an electrically insulating layer 32, e.g. a dielectric layer, such as for example a silicon oxide layer or a silicon nitride layer or a silicone layer, can be provided on the emitter layer 31, in any suitable way, e.g. by means of PECVD. Next an etching step may be performed for locally removing the dielectric layer 32 and the amorphous semiconductor emitter layer 31, thereby opening at least one window towards the underlying base layer 10 (FIG. 13). This patterning step can for example be performed using a polymeric masking layer and using an etchant that etches the dielectric layer 32 and the amorphous semiconductor layer 31. An amorphous semiconductor layer of the first dopant type, e.g. an n+ amorphous silicon layer 33 can then be deposited in any suitable way, e.g. by means of PECVD, at least at locations where the at least one window towards the base layer 10 is provided, to create a Back Surface Field in the base. Next this amorphous semiconductor layer of the first dopant type, e.g. n+ amorphous silicon layer 33 and the underlying dielectric layer 32 are patterned to provide an opening towards the underlying emitter layer 31. The resulting structure isschematically shown in FIG. 14.

After attaching the plurality of photovoltaic substrates 11 to the superstrate 20, and for example after performing at least part of the rear side processing, an encapsulation layer 13 may be provided at the backside of the photovoltaic substrates, as illustrated in FIG. 3. Providing the encapsulation layer 13 can be done by methods known by a person skilled in the art, such as for example blade coating, spray coating, knife-over-roll coating, dip coating or by means of printing techniques such as dispensing and gravure-printing, or by lamination. In some embodiments the encapsulation layer 13 can also be used for providing the electrically insulating layer 32 shown in FIG. 12.

At this stage of the process the photovoltaic substrates 11, 21 may be fully embedded, but at least part of the rear side processing still has to be performed, e.g. rear side contacts still have to be formed and the cells still have to be electrically interconnected. Therefore, the rear surface of the plurality of photovoltaic substrates 11, 21 needs to be cleared, e.g. the encapsulation layer 13 needs to be removed from the rear side of the plurality of photovoltaic substrates. This can be done in any suitable way, for example by laser ablation with a CO₂ laser. Process conditions may be selected such that the surface of the photovoltaic substrates 11, 21 is not damaged.

Alternatively, a patterned encapsulation layer 13 can be provided, e.g. the encapsulation layer 13 can be provided only in areas in between the photovoltaic substrates 11, 21, e.g. by means of screenprinting, dispensing, jetting or spray coating, such that the need for clearing the rear surface of the plurality of photovoltaic substrates 11, 21 after providing the encapsulation layer 13 isavoided.

After providing the encapsulation layer 13 a curing step may be performed for hardening the adhesive layer 12 and the encapsulation layer 13. The curing step may for example comprise heating to 80ºC in a furnace. FIG. 4 shows the structure at this stage of the process. The patterned encapsulation layer 13 may cover the sidewalls of the photovoltaic substrates 11, 21, such that short-circuits between n-type regions and p-type regionsof the photovoltaic cells resulting from a subsequent metallization step can be avoided. Stress relief features may be incorporated in the patterned encapsulation layer 13, in between the photovoltaic substrates 11, 21 such as e.g. bumps or holes for providing meandered interconnections. This is illustrated in FIG. 15. By providing stress relief features, electrical interconnections 16 on top of the encapsulation layer 13 may be less stressed during thermo-mechanical cycling.

In alternative embodiments, instead of providing a patterned encapsulation layer 13, the photovoltaic substrates 11 can be pressed in the adhesive layer, e.g. glue layer 12, such that excess glue fills the areas in between the photovoltaic substrates 11 and covers the sidewalls of the photovoltaic substrates adequately.

In a next step, electrical contacts are provided according to embodiments of the present invention to the plurality of photovoltaic substrates 21 with suitable patterns, e.g. finger patterns for forming the base and emitter contacts, and simultaneously in the same step the different photovoltaic cells are interconnected (thus forming a photovoltaic module). For this single or merged metallization step, there isa need for a process that does not lead to adegradation of any of the underlying layers. This implies that the process temperature needsto be sufficiently low and that any radiation or bombardment by degrading species during processing is advantageously avoided. The single metallization step may lead to a low ohmic contact resistance, e.g. an ohmic contact resistance below 0.1 Ohm cm², for example between 1 mΩ cm² and 0.1 Ω cm², with the p-type and n-type regions of the photovoltaic cells and it may allow forming a cell interconnection with a low ohmic series resistance (to minimize voltage losses and Joule heating), for example between 1 mΩ and 10 mΩ, e.g. between 1 mΩ and 5 mΩ, and a good step coverage (e.g. over the sides of the photovoltaic substrates). Furthermore a good adhesion to the underlying surfaces (photovoltaic substrates, encapsulation layer) isdesired. A method may be used that allows direct patterning. For example, screen printed polymeric pastes (such as e.g. Solamet PV410) can be used, or a seed layer can be formed followed by a plating step, or an evaporation or sputtering process can be used.

For example, a thin seed layer can be applied e.g. by jet printing, and subsequent electroplating can be used for increasing the aspect ratio of the metallization. Plating may provide a cheaper process than vacuum thin-film techniques, and may provide higher aspect ratios and therefore lower resistivities than screenprinting of low-temperature curing Ag pastes. Additionally, when using Cu plating, this might avoid possible future cost and supply issues related to Ag.

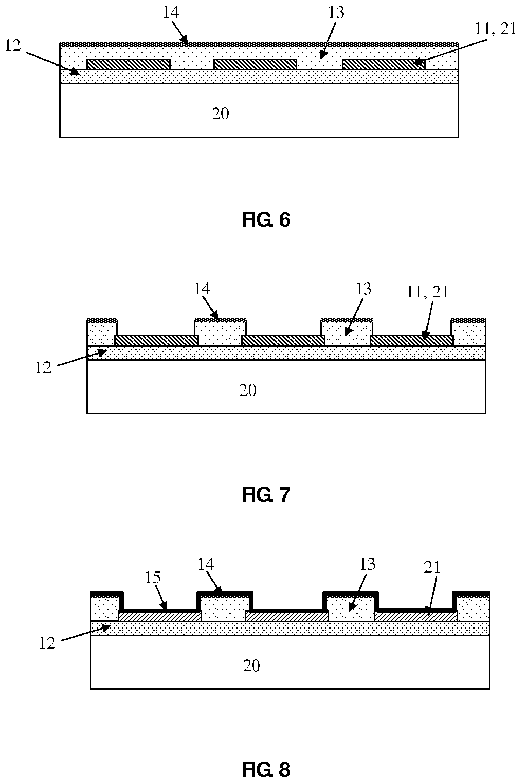

FIG. 6 to FIG. 8 illustrate process steps of a photovoltaic module fabrication process with merged metallization according to an embodiment of the present invention. In the example shown, after the photovoltaic substrates 11, 21 are fully embedded into the encapsulation layer 13 (as illustrated in FIG. 3), an absorbing layer 14 can be provided on top of the encapsulation layer 13 (FIG. 6). The absorbing layer 14 can for example comprise amorphous silicon or other suitable materials such as for example silicon oxide or silicon nitride. It may serve as a buffer for a seed layer patterning step that is performed at a later stage of the process. Providing an absorbing layer 14 is optional, e.g. the process may also be performed without providing an absorbing layer.

Then the rear surface of the plurality of photovoltaic substrates may be cleared, e.g. the encapsulation layer 13 may be removed at locations where the photovoltaic substrates 11, 21 are located. This may be done in any suitable way, e.g. by laser ablation with a CO₂ laser. Process conditions may be selected such that the rear surface of the photovoltaic substrates 11, 21 is not damaged. For example, the feasibility of this process step was experimentally confirmed using a laser with a power of 136 mW, a frequency of 100 Hz and a fluence of 2.1 J/m². Depending on the thickness of the encapsulation layer 13, e.g. 10 to 60 laser pulses may be needed to fully remove the encapsulation layer from the photovoltaic substrates. The resulting structure is shown in FIG. 7.

Next, the rear side of the photovoltaic substrates 11, 21 can be further processed as described above and a merged metallization step according to the present invention may be performed. In embodiments wherein the module fabrication process is performed without providing an absorbing layer 14, the merged metallization step according to embodiments of the present invention can be performed on a structure as shown in FIG. 4. In embodiments wherein an absorbing layer 14 is used, the merged metallization step may be performed on a structure as shown in FIG 7.

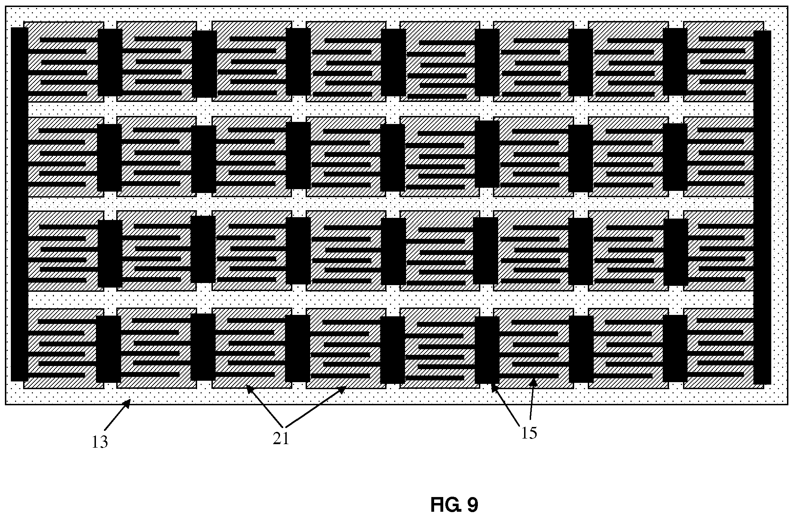

For forming the metallization layer, first a patterned seed layer 15 may be provided on the absorbing layer 14 (or directly on the encapsulation layer 13 in embodiments where no absorbing layer is used). This is illustrated in FIG. 8. FIG. 9 shows a top view of a structure that may be obtained at this stage of the module fabrication process, illustrating an exemplary seed layer pattern. Other suitable seed layer patterns may be used, e.g. depending on the required conductivity, surface recombination considerations or use of the electrical contacts as a reflector (in which case as much coverage as possible may be advantageous).

Providing the seed layer 15 can comprise providing directly a patterned layer, e.g. by means of printing techniques such as ink-jetting or aerosol jetting. Alternatively, providing the seed layer 15 may comprise providing a layer on the whole surface, e.g. by means of thin-film techniques such as evaporation or sputtering (e.g. Ti, Cu, Ni, ..), followed by a patterning step. This patterning step may for example be performed by means of laser ablation. A laser may be used with a wavelength that is absorbed as much as possible by the seed layer 15, but that only minimally affects the encapsulation material 13. A previously deposited absorbing layer 14 hereby may act as a layer protecting the photovoltaic cells and protecting the embedding material where the patterning provides interconnection in between the cells. Experiments indicate that a YAG laser or another UV laser can be used for patterning the seed layer 15.

Experiments were performed using a Trumark laser (355 nm). To find a range of suitable laser parameters, a test matrix for laser ablation with different power settings (10 to 100% of maximum power) and pulse frequencies (10 kHz to 100 kHz) was used for forming a laser ablated pattern. For these experiments, different metal layers and different substrates were evaluated: Ni on polished Si, 30 nm Ti on rough (as-cut) Si, 30 nm Ti on silicone, a 40 nm stack of a-Si/Ti on rough silicon, and a 40 nm thick stack of a-Si/Ti on silicone. Good results were obtained for Ni on polished silicon and for Ti and a-Si/Ti on rough silicon. Also the results of laser ablation of metal on a silicone indicate the possibility of patterning the metal layer without significantly damaging the underlying silicone. There seemsto exist a broad range of parameters in which the metal can be ablated before the silicone is affected. Good results were obtained with the following laser powers and frequencies varying over a broad range around: 30% of maximum power at 10 kHz, 40%of maximum power at 10-20 kHz, 50%of maximum power at 20-30 kHz, 60%of maximum power at 30-40 kHz, 70%of maximum power at 40-50 kHz, 80%of maximum power at 50-60 kHz, 90%of maximum power at 60-70 kHz, 100%of maximum power at 70-80 kHz, for the ablation of Ni on top of silicon (Si). Ablation experiments with Ti on silicone showed that a little less power may be needed for ablation on top of the silicone: good resultswere obtained with 10-20% of maximum power at 10 kHz, 30% of maximum power at 20 kHz, 40% of maximum power at 20-30 kHz, 50% of maximum power at 40-50 kHz, 60%of maximum power at 50-60 kHz, 70%of maximum power at 70-80 kHz, 80%of maximum power at 80-90 kHz, 90%of maximum power at 90-100 kHz, 100%of maximum power at 100 kHz. The number of pulses may not strongly influence the results obtained. However, in case of a plurality of consecutive pulses on a same spot, heating may affect the results obtained. On the other hand, in view of a good process control and depending on the stability of the laser in terms of power per pulse, it may be beneficial to use a plurality of pulses at a lower power level rather than one pulse at a higher power level.

The seed layer 15 may provide a low ohmic contact to the n-type and p-type semiconductor layers, e.g. to the n-type and p-type regions of the photovoltaic cells. It is advantageous if the deposition process does not degrade any of the underlying layers (e.g. embedding material and cell surface), and the seed layer 15 may adhere well to these underlying layers.

Next a plating step may be performed as part of the rear side metallization process. For example, starting from a Ti/Cu (30nm/150nm) seed layer 15, a Cu layer may be provided by means of a plating process.

After that, outside module contacts can be provided, e.g. by soldering, gluing or welding tabbing strings (e.g. Sn-coated Cu strings) to predetermined areas of the rear side metallization. Finally, another encapsulation layer may be applied at the back side of the module, e.g. for protecting the metallization against corrosion. This encapsulation layer may adhere well to the photovoltaic cells, to the adhesive layer 12 and to the metallization, and has as a primary function the protection of the whole assembly against effects of the environment, mainly moisture and thermally induced stresses. Depending on the heat dissipation of the embedded cells and metallization, it may also act as heat sink, in which case a high thermal conductivity is advantageous. For example, a silicone layer, e.g. a PV6010 Cell Encapsulant layer can be used. This layer has to provide a full protection of the photovoltaic cells to the ambient conditions typically encountered by photovoltaic cells. As a typical requirement, the photovoltaic modules have to withstand the testing as described in IEC 61215 or IEC 61646. Also, the encapsulation layer should be easily removed at the location of the module contacts. A suitable encapsulation layer is silicone that can be applied by coating, e.g. blade coating, or lamination and in which openings (vias) can be made by e.g. laser ablation.

In embodiments of the present invention, the outside module contacts can also be provided on the superstrate 20 instead of on the encapsulation layer 13, e.g. to avoid pressure on the metallization during contact welding. This would require an additional step for opening windows towards the superstrate, e.g. by means of laser drilling.

Advanced stress relief techniques may be used in view of the reliability of the interconnection pattern during thermal cycling. For example, meandering interconnections can be provided (e.g. horizontal meanders or vertical meanders as illustrated in FIG. 15) in between the plurality of photovoltaic cells.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel featuresof the invention as applied to various embodiments, it will be understood that various omissions, substitutions, and changes in the form and details of the device or process illustrated may be made by those skilled in the technology.

## Claims

1. Method for fabricating a photovoltaic module comprising a plurality of photovoltaic cells, the method comprising
providing a plurality of photovoltaic substrates (11) having a front side,
attaching the plurality of photovoltaic substrates (11) to a transparent carrier (20) with the front side of the photovoltaic substrates (11) facing the carrier (20), and
rear side processing of the plurality of photovoltaic substrates (11) for forming photovoltaic cells (21),
wherein rear side processing comprises a single metallization process for forming electrical contacts to n-type regions and to p-type regions at the rear side of the plurality of photovoltaic cells (21) and for electrically interconnecting the photovoltaic cells (21) within the photovoltaic module, the single metallization process being performed using a direct patterning method.

2. A method according to claim 1, wherein the single metallization process comprises forming a patterned seed layer (15) by inkjet printing or by aerosol jetting and performing a metal plating step.

3. A method according to claim 1, wherein the single metallization process comprises performing a screen printing step using a low temperature curing metal paste.

4. A method according to any of the previous claims, furthermore comprising providing stress relief structures for limiting stress in metal interconnections between photovoltaic cells.

5. A method according to any of the previous claims, furthermore comprising encapsulating the plurality of photovoltaic cells (21).

6. A method according to any of the previous claims, wherein rear side processing is performed after attaching the plurality of photovoltaic substrates (11) to the transparent carrier (20).

7. A method according to claim 6, wherein rear side processing furthermore comprises one or more of the following rear side processing steps: coating, diffusion of dopants, deposition of layers, etching, applying lithographic steps, locally removing part of deposited layers, growth of at least one epitaxial layer, a printing step.

8. A method according to any of the previous claims, wherein rear side processing is carried out at temperatures sufficiently low to prevent deterioration of materials used.

9. A photovoltaic module comprising a plurality of photovoltaic cells (21) which are electrically interconnected,
wherein a single, directly patterned metallization level is used for making electrical contacts to n-type regions and to p-type regions at the back side of the plurality of photovoltaic cells (21) and for electrically interconnecting photovoltaic cells (21) within the module.

10. A photovoltaic module according to claim 9, wherein the single metallization level comprises a stack of layers.

11. A photovoltaic module according to any of claims 9 or 10, wherein the single metallization level has an equivalent contact resistance to the n-type and p-type regions of the photovoltaic cells (21) of less than 0.1 Ohm cm².

12. A photovoltaic module according to any of claims 9 to 11, wherein the plurality of photovoltaic cells (21) are attached to a transparent carrier (20).

13. A photovoltaic module according to claim 12, wherein the transparent carrier (20) is a flexible carrier.

14. Use of a method according to any of claims 1 to 8 for fabricating photovoltaic modules comprising back contact photovoltaic cells (21).

## Patentansprüche

1. Verfahren zum Herstellen eines Photovoltaikmoduls, das eine Vielzahl von Photovoltaikzellen umfasst, wobei das Verfahren umfasst
Bereitstellen einer Vielzahl von Photovoltaiksubstraten (11), die eine Vorderseite besitzen,
Befestigen der Vielzahl von Photovoltaiksubstraten (11) auf einem transparenten Träger (20), mit der Vorderseite der Photovoltaiksubstrate (11) dem Träger (20) zugewandt, und
Bearbeiten der Hinterseite der Vielzahl von Photovoltaiksubstraten (11), um Photovoltaikzellen (21) zu bilden,
wobei das Bearbeiten der Hinterseite einen einzelnen Metallisierungsprozess umfasst, um elektrische Kontakte zu N-Typ-Regionen und zu P-Typ-Regionen auf der Hinterseite der Vielzahl von Photovoltaikzellen (21) zu bilden, und um die Photovoltaikzellen (21) innerhalb des Photovoltaikmoduls elektrisch miteinander zu verbinden, wobei der einzelne Metallisierungsprozess unter Verwendung eines direkten Musterbildungsverfahrens durchgeführt wird.

2. Verfahren nach Anspruch 1, wobei der einzelne Metallisierungsprozess das Bilden einer gemusterten Keimschicht (15) durch Tintenstrahldruck oder durch Aerosoldruck und Durchführen eines Metallplattierungsschrittes umfasst.

3. Verfahren nach Anspruch 1, wobei der einzelne Metallisierungsprozess das Durchführen eines Siebdruckschrittes unter Verwendung einer bei niedriger Temperatur aushärtenden Metallpaste umfasst.

4. Verfahren nach einem der vorstehenden Ansprüche, weiterhin das Bereitstellen von Spannungsentlastungsstrukturen umfassend, um Spannung in Metallverbindungen zwischen Photovoltaikzellen zu begrenzen.

5. Verfahren nach einem der vorstehenden Ansprüche, weiterhin das Verkapseln der Vielzahl von Photovoltaikzellen (21) umfassend.

6. Verfahren nach einem der vorstehenden Ansprüche, wobei das Bearbeiten der Hinterseite nach dem Befestigen der Vielzahl von Photovoltaiksubstraten (11) auf dem transparenten Träger (20) durchgeführt wird.

7. Verfahren nach Anspruch 6, wobei das Bearbeiten der Hinterseite weiterhin einen oder mehrere der folgenden Schritte zum Bearbeiten der Hinterseite umfasst: Beschichten, Eindiffundieren von Dotierungsmitteln, Abscheiden von Schichten, Ätzen, Anwenden von lithographischen Schritten, lokales Entfernen eines Teils von abgeschiedenen Schichten, Aufwachsen von mindestens einer epitaxialen Schicht, einen Bedruckungsschritt.

8. Verfahren nach einem der vorstehenden Ansprüche, wobei das Bearbeiten der Hinterseite bei Temperaturen ausgeführt wird, die ausreichend niedrig sind, um Beschädigung von verwendeten Materialien zu verhindern.

9. Photovoltaikmodul, umfassend eine Vielzahl von Photovoltaikzellen (21), die elektrisch miteinander verbunden sind,
wobei eine einzelne, direkt gemusterte Metallisierungsebene verwendet wird, um elektrische Kontakte zu N-Typ-Regionen und zu P-Typ-Regionen auf der Rückseite der Vielzahl von Photovoltaikzellen (21) aufzubauen, und um die Photovoltaikzellen (21) innerhalb des Moduls elektrisch miteinander zu verbinden.

10. Photovoltaikmodul nach Anspruch 9, wobei die einzelne Metallisierungsebene einen Schichtenstapel umfasst.

11. Photovoltaikmodul nach einem der Ansprüche 9 oder 10, wobei die einzelne Metallisierungsebene einen gleichwertigen Kontaktwiderstand zu den N-Typ- und P-Typ-Regionen der Photovoltaikzellen (21) von weniger als 0,1 Ohm cm² besitzt.

12. Photovoltaikmodul nach einem der Ansprüche 9 bis 11, wobei die Vielzahl von Photovoltaikzellen (21) auf einem transparenten Träger (20) befestigt sind.

13. Photovoltaikmodul nach Anspruch 12, wobei der transparente Träger (20) ein biegsamer Träger ist.

14. Verwendung eines Verfahrens nach einem der Ansprüche 1 bis 8 zum Herstellen von Photovoltaikmodulen, die rückseitenkontaktierte Photovoltaikzellen (21) umfassen.

## Revendications

1. Procédé de fabrication d'un module photovoltaïque comprenant une pluralité de cellules photovoltaïques, le procédé comprenant :
la fourniture d'une pluralité de substrats photovoltaïques (11) comportant un côté avant,
l'attachement de la pluralité de substrats photovoltaïques (11) à un support transparent avec le côté avant des substrats photovoltaïques (11) faisant face au support (20), et
le traitement de côté arrière de la pluralité de substrats photovoltaïques (11) pour former des cellules photovoltaïques (21),
dans lequel le traitement de côté arrière comprend un processus de métallisation unique pour former des contacts électriques dans des régions de type n et dans des régions de type p sur le côté arrière de la pluralité de cellules photovoltaïques (21) et pour interconnecter électriquement les cellules photovoltaïques (21) à l'intérieur du module photovoltaïque, le processus de métallisation unique étant effectué en utilisant un procédé de structuration directe.

2. Procédé selon la revendication 1, dans lequel le processus de métallisation unique comprend la formation d'une couche de germe structurée (15) par impression à jet d'encre ou par jet d'aérosol et l'exécution d'une étape de placage métallique.

3. Procédé selon la revendication 1, dans lequel le processus de métallisation unique comprend l'exécution d'une étape de sérigraphie en utilisant une pâte métallique à durcissement à basse température.

4. Procédé selon l'une quelconque des revendications précédentes, comprenant en outre la fourniture de structures de détente de tension pour limiter toute tension dans des interconnexions métalliques entre des cellules photovoltaïques.

5. Procédé selon l'une quelconque des revendications précédentes, comprenant en outre l'encapsulation de la pluralité de cellules photovoltaïques (21).

6. Procédé selon l'une quelconque des revendications précédentes, dans lequel le traitement de côté arrière est effectué après l'attachement de la pluralité de substrats photovoltaïques (11) au support transparent (20).

7. Procédé selon la revendication 6, dans lequel le traitement de côté arrière comprend en outre une ou plusieurs des étapes de traitement de côté arrière suivantes : l'enduit, la diffusion de dopants, le dépôt de couches, le mordançage, l'application d'étapes lithographiques, l'enlèvement local d'une partie de couches déposées, la croissance d'au moins une couche épitaxiale, une étape d'impression.

8. Procédé selon l'une quelconque des revendications précédentes, dans lequel le traitement de côté arrière est effectué à des températures suffisamment basses pour empêcher toute détérioration de matériaux utilisés.

9. Module photovoltaïque comprenant une pluralité de cellules photovoltaïques (21) qui sont interconnectées électriquement,
dans lequel un niveau de métallisation unique à structuration directe est utilisé pour établir des contacts électriques dans des régions de type n et des régions de type p sur le côté arrière de la pluralité de cellules photovoltaïques (21) et pour interconnecter électriquement des cellules photovoltaïques (21) à l'intérieur du module.

10. Module photovoltaïque selon la revendication 9, dans lequel le niveau de métallisation unique comprend une pile de couches.

11. Module photovoltaïque selon la revendication 9 ou 10, dans lequel le niveau de métallisation unique présente une résistance de contact équivalente dans les régions de type n et de type p des cellules photovoltaïques (21) qui est inférieure à 0,1 ohm cm².

12. Module photovoltaïque selon l'une quelconque des revendications 9 à 11, dans lequel la pluralité de cellules photovoltaïques (21) sont attachées à un support transparent (20).

13. Module photovoltaïque selon la revendication 12, dans lequel le support transparent (20) est un support souple.

14. Utilisation d'un procédé selon l'une quelconque des revendications 1 à 8 pour la fabrication de modules photovoltaïques comprenant des cellules photovoltaïques à contact arrière (21).
